# EUROPEAN PATENT SPECIFICATION

(11) **EP 0 457 310 B1**
(45) Date of publication and mention of the grant of the patent: **07.01.1998**
(21) Application number: 91107882.2
(22) Date of filing: 15.05.1991
(51) Int. Cl.: G11C 11/406

(54) **Memory card**
Speicherkarte
Carte de mémoire

(30) Priority: 15.05.1990 JP 124753/90; 16.05.1990 JP 126143/90; 23.05.1990 JP 133223/90; 29.05.1990 JP 138974/90
(43) Date of publication of application: 21.11.1991
(73) Proprietor: SEIKO EPSON CORPORATION, Shinjuku-ku Tokyo-to (JP)
(72) Inventor: Sakurada, Noriaki, Suwa-shim, Nagano (JP); Sugimoto, Fujikazu, Suwa-shim, Nagano (JP); Kobayashi, Ichiro, Suwa-shim, Nagano (JP)
(74) Representative: Hoffmann, Eckart, Dipl.-Ing.

(56) References cited:
- EP-A- 0 338 528
- EP-A- 0 352 768
- US-A- 4 393 477

## Description

This invention relates generally to computer semiconductor memory cards based on dynamic random access memory (DRAM) devices and which consequently involve DRAM refresh operations, and in particular this invention relates to devices and methods that provide for refreshing of the DRAM devices on plug-in boards in an automatic way that is self-contained on the memory card and optimum for whatever type of DRAM devices are being used.

The use of DRAM for main memory and for expansion board memory is conventional in personal computer systems. The fact that DRAM-type memories need outside stimulus to "refresh" their individual memory cells periodically is well-known to those skilled in the art. See, "DRAM Refresh Modes," Motorola Semiconductor Application Note AN987, Motorola Memory Data, ref. 6, 1990, pp 13-2 to 13-3.

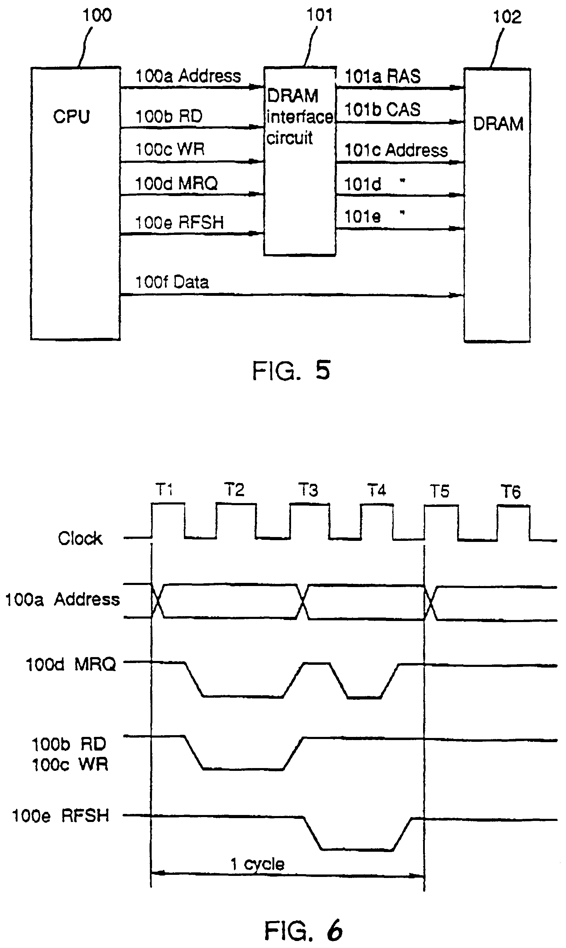

Fig. 5 is a schematic diagram of a common prior art interfacing of a computer with DRAM. In the Figure, 100 is the CPU, and to access (read or write) the DRAM 102, it outputs the address signal 100a, the read signal (RD) 100b or write signal (WR) 100c and the memory request signal (MRQ) 100d to a DRAM interface circuit 101 and outputs the data signal 100f to the DRAM 102. In addition to the above signals, the CPU 100 outputs the refresh signal (RFSH) 100e during refresh operation to the DRAM interface circuit.

The DRAM interface circuit 101 comprises a row address generation circuit, a column address generation circuit, etc., and to read or write the DRAM 102, it outputs the row address strobe signal (RAS signal) 101a, column address strobe signal (CAS signal) 101b and address signals 101c, 101d and 101e based on the address signal 100a, RD signal 100b or WR signal 100c, and MRQ signal 100d from the CPU. During refresh operation, the RAS signal 101a, CAS signal 101b and address signals 101c, 101d and 101e are output to the DRAM 102 to retain the data stored in the DRAM 102.

Common circuits of the prior art in which the DRAM is connected to the CPU are configured as described above, and Fig. 6 is a timing chart showing the timing with which the CPU accesses the DRAM, and it describes the operation.

In the Figure, when the DRAM 102 is being accessed (read or write), the CPU outputs the address signal 100a, memory request (MRQ) signal 100d and read (RD) signal 100b or write (WR) signal 100c to the DRAM interface circuit 101, and the DRAM interface circuit 101 outputs the decoded address signals 101c, 101d and 101e, the RAS signal 101a, the CAS signal 101b and the data signal 100f to the DRAM 102 and stores data at or fetches data from the prescribed address.

Further, a refresh generation circuit (e.g. a software program) is built into the CPU 100 and outputs the refresh signal (RFSH) to the DRAM interface circuit 101 (the address signal 100a and MRQ signal 100d are also output) after a read or write operation, and the DRAM interface circuit 101 outputs the RAS signal 101a, CAS signal 101b and address signals 101c, 101d and 101e to refresh the DRAM 102 and retain the data stored at the prescribed addresses in the DRAM 102. The refresh operation is not initiated by the CPU at arbitrary times, but rather at a prescribed timing (after fetching of operation code).

Memory cards are convenient way for users to add more memory to computer systems. Such cards can be plugged into sockets universally provided standard on most popular systems. Some of these prior art memory cards do not initiate their own refresh cycles. Such memory cards include only the equivalent function of DRAM 102.

Further, since the timing of the refresh signal differs depending on the CPU in the main unit, the CPU cannot supply an optimum refresh signal to DRAM-equipped memory cards, and also since the refresh cycle (required number of refresh operations per unit time) of the DRAM of each memory card differs, the CPU cannot supply an optimum refresh signal to every memory card.

In addition, since a read operation or write operation and a refresh operation for retaining the data stored in the DRAM have to be performed during one access cycle, the access time of the memory card became longer.

The document US-A-4,393,477 discloses a DRAM circuit with a temperature-compensated internal refresh function. The DRAM includes an oscillator having a frequency characteristic with a positive temperature coefficient and means for generating refresh signals on the basis of the oscillation period of the oscillator circuit. Refresh operation is performed in response to these refresh signals.

The document EP-A-0 352 768 discloses a DRAM circuit which is refreshed in response to external refresh signals and comprises two counters and a comparator for comparing the logic states of the counters. The number of refreshing operations actually executed is counted by one counter while the number of refreshing operations actually reqired is counted by the other counter. If the logic states do not coincide a refreshing operation is perforemd in response to an external refresh request signal while otherwise the refresh request signal is ignored.

The present invention is intended to solve the above problems, and its object is to offer a memory card that automatically performs refresh control by itself to supply an optimum refresh signal and separates the read-write operation and refresh operation to shorten the access time of the memory card and provide compatibility with stable operation.

This object is achieved with a memory card as claimed in claim 1.

In an embodiment of the invention, a clock pulse is generated from an oscillation source in the memory card, and refresh generation means perform refresh operation automatically based on the clock pulse. A refresh generation circuit outputs a refresh signal based on the clock pulse. A refresh/read-write operation setting means compares the value of a counter circuit counting the clock pulses from the oscillation source with a value set by the read-write operation enable period setting circuit for the read-write operation period of the DRAM on the memory card, and if they are the same, then it outputs a read-write selection signal, and if they are different, then it outputs a refresh selection signal. The read-write selection signal and the refresh selection signal from the read-write/refresh operation setting means are stored in registers of identification means and posted externally from the registers via a third multiplexer, and only when the posted information is a read-write selection signal, then a read-write operation signal is output to the read-write operation from outside the memory card and the DRAM is accessed. Further, when the above information from the identification means is a refresh selection signal, then the CPU knows that the DRAM cannot be accessed from outside the memory card and continues to read the information from the identification means while the DRAM is refreshed from inside the memory card. By providing a delay circuit between the comparator circuit of the read-write operation setting means and the third multiplexer of the refresh/read-write selection means, the DRAM can be accessed from outside the memory card from the read-write period set by the refresh/read-write operation setting means to the initial refresh period.

A clock pulse is generated from the oscillation source inside the memory card, and the control means performs a refresh operation based on the clock pulse. It also stops refresh operation and sets the DRAM in the memory card to a standby condition when it receives a dummy signal from outside the memory card during refresh operation, and upon completion of the standby condition, it performs read-write operation or refresh operation.

Specific embodiments of the present invention will be described in detail below with reference to the drawings, in which:
- Fig. 1: is a block diagram of the memory card of a first embodiment;
- Fig. 2: is a timing chart showing the access condition of the memory card in Fig. 1;
- Fig. 3: is a block diagram of the memory card of a second embodiment;
- Fig. 4: is a timing chart showing the access condition of the memory card in Fig. 3;
- Fig. 5: is a timing chart showing access of the DRAM by the CPU in the prior art; and
- Fig. 6: is a timing chart showing access of the DRAM by the CPU in Fig. 5.

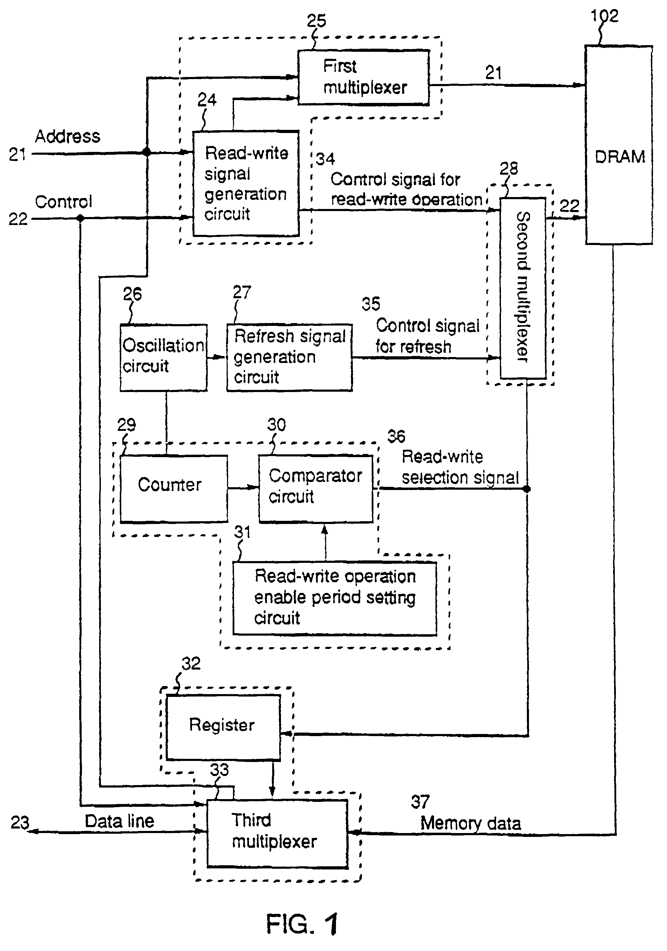

Fig. 1 is a block diagram of the memory card of a first embodiment, where 102 is the same as in Fig. 5. In the Figure, 21 and 22 are the address signal and control signal input, respectively, from the external CPU. A data bus line 23 transfers data between the external CPU and the memory card, and it is connected to a third multiplexer 33 (described below) on the memory card. A read-write signal generation circuit 24 uses the address signal 21 and control signal 22 from the external CPU to generate a read-write operation control signal 34 which controls read and write operation of the DRAM 102, and it outputs an enable signal to a first multiplexer 25 (described below). The first multiplexer 25 is controlled by the enable signal from the read-write signal generation circuit 24 to output the address signal 21 from the external CPU to the DRAM 102. An oscillation circuit 26 includes a quartz resonator, and outputs a clock signal oscillated at a fixed period to a refresh signal generation circuit 27 (described below) and a counter circuit 29 (described below).

The refresh signal generation circuit 27 outputs a control signal 35 for refresh operation based on the clock signal from the oscillation circuit 26. A second multiplexer 28 is controlled by a read-write selection signal 36 (described below) to output either the control signal 34 for read-write control form the read-write signal generation circuit 24 or the control signal 35 for refresh from the refresh signal generation circuit 27 to the DRAM 102. A counter 29 counts the clock signal from the oscillation circuit 26 and outputs it to a comparator circuit 30. The comparator circuit 30 compares the count signal from the counter 29 and a value set by the read-write operation enable period setting circuit 31, and outputs the read-write selection signal 36 to the second multiplexer 28. The read-write operation enable period setting circuit 31 arbitrarily sets, outside the memory card, the read-write operation time corresponding to the DRAM on the memory card. A register 32 temporarily stores the read-write selection signal 36 from the comparator circuit 30, and it also outputs the stored read-write selection signal 36 to the third multiplexer 33. The third multiplexer 33 posts either the read-write selection signal 36 from the register 32 or the memory data 37 read from the DRAM 102 to the external CPU via the data bus line 23 by means of the address signal 21 and the control signal 22 from the external CPU.

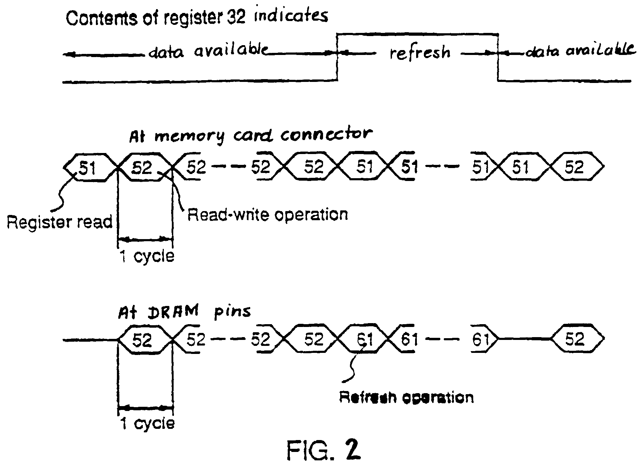

Fig. 2 is a timing chart showing access to the memory card in Fig. 1 and describes its operation.

The external CPU outputs the address signal 21 and the control signal 22 to the first multiplexer 25 and the third multiplexer 33, respectively, and checks the contents of the register 32, and if the contents of the register 32 indicate active, then it executes read-write control. Therefore, it outputs the prescribed address signal 21 and the control signal 22 to the read-write signal generation circuit 24 and the address signal 21 also to the first multiplexer 25. Also, the control signal 34 for read-write operation generated from the read-write signal generation circuit 24 is selected by the second multiplexer 28 according to the read-write selection signal 36 output from the comparator circuit 30 and is output to the input for read or write control of the DRAM 102. The enable signal from the read-write signal generation circuit 24 causes the first multiplexer 25 to select the address signal 21 and to output it to the input for DRAM 102 addresses, and therefore the prescribed data is read from or written to the prescribed addresses in the DRAM 102.

The external CPU checks the contents of the register 32 as described above. As long as the contents of the register 32 indicate non-active, the control signal 35 for refresh generated by the oscillation circuit 26 in the memory card and the refresh signal generation circuit 27 is selected by the second multiplexer 28, refresh operation for retaining the data in the DRAM 102 is performed automatically, and the external CPU cannot access the DRAM 102 to perform read-write operation. The CPU keeps reading the contents of the register 32 until the contents of the register 32 indicate active. The above refresh operation is performed the necessary number of times in a single burst.

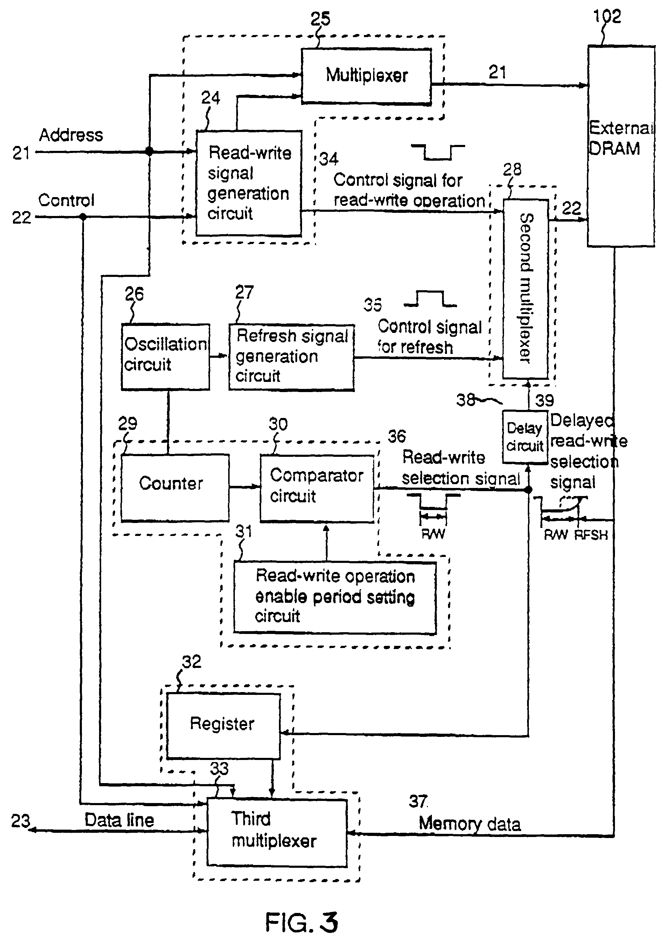

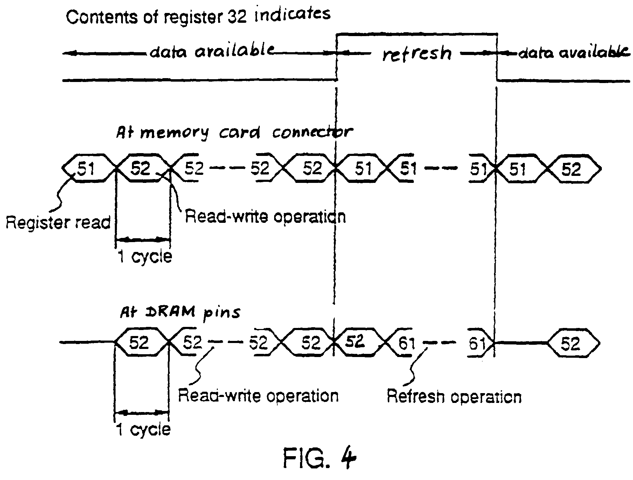

The memory card of a second embodiment is shown in Fig. 3 and Fig. 4 is a timing chart showing access to the memory card in Fig. 3 and describing its operation. This embodiment differs from that of Fig. 1 by the provision of a delay circuit 38 as will be explained.

In the Figure, the external CPU outputs the address signal 21 and the control signal 22 to the first multiplexer 25 and the third multiplexer 33, respectively, and checks the contents of the register 32, and if the contents of the register 32 indicate active, then it executes read-write control. In this case, the output of the read-write selection signal 36 from the comparator circuit 30 to the second multiplexer 28 is delayed by the delay circuit 38, and therefore, as shown in Fig. 4, even if the contents of the register 32 are positive, the control signal 34 for read-write operation from the read-write signal generation circuit 24 is output during the delay time and the read-write operation period can be delayed. Following this, refresh operation in the memory card is immediately executed automatically while the contents of the register 32 indicate active.

As described above, according to the invention, an oscillation source is included in the memory card and refresh operation is preformed automatically, and therefore no refresh signals need to be received from outside the memory card. Also, since the timing of the refresh signal need not be considered in the interface with a main unit, when the memory card is used with the interface of a different unit, read-write operation is performed according to the read-write signal from the main unit while giving preference to the refresh operation in the memory card, whereby a memory card with broad applicability is achieved.

In addition, the read-write period and refresh period are separated in the memory card and posted externally, and therefore the memory card need only be accessed during the read-write period, thus eliminating access during the refresh period and shortening the access time of the memory card.

Further, by delaying the read-write period in the memory card so it extends into the refresh period, read-write operation can be performed during that delay time, thus increasing the utility of the memory card.

## Claims

1. A memory card comprising
a DRAM (102) requiring refresh operation,
oscillation means (26) generating a clock pulse;
a refresh signal generation circuit (27) for generating a refresh control signal (35) based on said clock pulse,
read-write control means (24, 25) responsive to an external address signal and control signal applied to the memory card, for passing the external address signal to the DRAM (102) and for generating a read-write control signal (34),
refresh/read-write operation setting means (29, 30, 31) including a counter (29) counting said clock pulses for comparing the count value of said counter and a set value which determines a read-write operation period of the DRAM, and for putting out a refresh selection signal (36) when these values are the same and a read-write selection signal (36) when they are different,
refresh/read-write selection means (28) responsive to said refresh selection signal and said read-write selection signal for applying, in response to the former, said refresh control signal (35) to the DRAM, and for applying, in response to the latter, said read-write control signal (34) to the DRAM, and
identification means (32) that externally posts said refresh selection signal and said read-write selection signal,
wherein refresh operations are automatically performed based on said clock pulse and independent of external refresh operations.

2. The memory card of claim 1 wherein
said read-write control means comprises a read-write signal generation circuit (24) for generating said read-write control signal and an enable signal, and a first multiplexer (25) for applying said external address signal to the DRAM (102) in response to the enable signal;
said refresh/read-write operation setting means further comprises a read-write operation enable period setting circuit (31), in which said read-write operation period of the DRAM (102) is arbitrarily set, and a comparator circuit (30) receiving said count value and said set read-write operation period for putting out either said refresh selection signal (36) or said read-write selection signal (36);
said refresh/read-write selection means comprises a second multiplexer (28) receiving said read-write control signal and said refresh control signal and having its control input connected to the output of said comparator circuit (30);
said identification means (32) comprises at least one register for storing the read-write selection signal and refresh selection signal from the comparator circuit (30), and
a third multiplexer (33) responsive to said external address signal and control signal is provided for selecting either the output data from said register for output via a data line (23) or memory data for output from or input to the DRAM via said data line.

3. The memory card of claim 2 wherein a delay circuit (38) is inserted between the comparator circuit (30) and the second multiplexer (28) to delay the rise time of the refresh operation.

## Patentansprüche

1. Speicherkarte umfassend
ein DRAM (102), das eine Auffrischoperation benötigt,
eine Oszillationseinrichtung (26), die einen Taktimpuls erzeugt;
eine Auffrischsignal-Erzeugungsschaltung (27) zum Erzeugen eines Auffrisch-Steuersignals (35) auf der Basis des Taktimpulses,
eine Lese/Schreib-Steuereinrichtung (24, 25), die auf ein externes Adressensignal und ein Steuersignal anspricht, die an die Speicherkarte angelegt werden, zum Weiterleiten des externen Adressensignals an das DRAM (102) und zum Erzeugen eines Lese/Schreib-Steuersignals (34),
eine Auffrisch/Lese/Schreiboperations-Einstelleinrichtung (29, 30, 31) mit einem die Taktimpulse zählenden Zähler (29) zum Vergleichen des Zählwerts des Zählers und eines eingestellten Werts, der eine Lese/Schreib-Operationsperiode des DRAMs bestimmt, und zum Ausgeben eines Auffrisch-Auswahlsignals (36), wenn diese Werte gleich sind, und eines Lese/Schreib-Auswahlsignals (36), wenn sie verschieden sind,
eine Auffrisch/Lese/Schreib-Auswahleinrichtung (28), die auf das Auffrisch-Auswahlsignal und das Lese/Schreib-Auswahlsignal anspricht, zum Anlegen, in Anwort auf ersteres, des Auffrisch-Steuersignals (35) an das DRAM und zum Anlegen, in Antwort auf letzteres, des Lese/Schreib-Steuersignals (34) an das DRAM, und
eine Identifizierungseinrichtung (32), die das Auffrisch-Auswahlsignal und das Lese/Schreib-Auswahlsignal nach außen signalisiert,
wobei Auffrischoperationen automatisch auf der Basis des Taktimpulses und unabhängig von externen Auffrischoperationen ausgeführt werden.

2. Speicherkarte nach Anspruch 1, bei der
die Lese/Schreib-Steuereinrichtung eine Lese/Schreibsignal-Erzeugungsschaltung (24) zum Erzeugen des Lese/Schreib-Steuersignals und eines Freigabesignals sowie einen ersten Multiplexer (25) zum Anlegen des externen Adressensignals an das DRAM (102) in Antwort auf das Freigabesignal aufweist;
die Auffrisch/Lese/Schreiboperations-Einstelleinrichtung des weiteren eine Einstellschaltung (31) für die Lese/Schreiboperations-Freigabeperiode, in der die Lese/Schreib-Operationsperiode des DRAM (102) beliebig einzustellen ist, und eine Komparatorschaltung (30) aufweist, die den Zählwert und die eingestellte Lese/Schreib-Operationsperiode zum Ausgeben entweder des Auffrisch-Auswahlsignals (36) oder des Lese/Schreib-Auswahlsignals (36) empfängt;
die Auffrisch/Lese/Schreib-Auswahleinrichtung einen zweiten Multiplexer (28) aufweist, der das Lese/Schreib-Steuersignal und das Auffrisch-Steuersignal empfängt und dessen Steuereingang mit dem Ausgang der Komparatorschaltung (30) verbunden ist;
die Identifizierungseinrichtung (32) zumindest ein Register zum Speichern des Lese/Schreib-Auswahlsignals und des Auffrisch-Auswahlsignals aus der Komparatorschaltung (30) aufweist, und
ein dritter Multiplexer (33), der auf das externe Adressensignal und das Steuersignal anspricht, zum Auswählen entweder der Ausgabedaten aus dem Register zur Ausgabe über eine Datenleitung (23) oder der Speicherdaten zur Ausgabe aus dem DRAM oder zur Eingabe in dieses über die Datenleitung vorgesehen ist.

3. Speicherkarte nach Anspruch 2, bei der eine Verzögerungsschaltung (38) zwischen die Komparatorschaltung (30) und den zweiten Multiplexer (28) geschaltet ist, um die Anstiegszeit der Auffrischoperation zu verzögern.

## Revendications

1. Carte à mémoire comportant
une DRAM (102) exigeant une opération de régénération,
des moyens (26) d'oscillation générant une impulsion d'horloge ;
un circuit (27) de production de signal de régénération destiné à produire un signal (35) de commande de régénération basé sur l'impulsion d'horloge,
des moyens (24, 25) de commande de lecture-écriture qui, en réponse à un signal d'adresse extérieure et à un signal de commande extérieure appliqués à la carte à mémoire, permettent de faire passer le signal d'adresse extérieure vers la DRAM (102) et de produire un signal (34) de commande de lecture-écriture,
des moyens (29, 30, 31) de réglage d'une opération de lecture-écriture/régénération, comportant un compteur (29) comptant les impulsions d'horloge destinés à comparer la valeur de comptage du compteur et une valeur réglée qui détermine une durée d'opération de lecture-écriture de la DRAM, et destinés à émettre en sortie un signal (36) de sélection de régénération lorsque ces valeurs sont les mêmes et un signal (36) de sélection de lecture-écriture lorsqu'elles sont différentes,
des moyens (28) de sélection de lecture-écriture/régénération qui, en réponse au signal de sélection de régénération et au signal de sélection de lecture-écriture, appliquent, en réponse au premier nommé, le signal (35) de commande de régénération à la DRAM et applique, en réponse au dernier nommé, le signal (34) de commande de lecture-écriture à la DRAM, et
des moyens (32) d'identification qui envoient à l'extérieur le signal de sélection de régénération et le signal de sélection de lecture-écriture,
les opérations de régénération étant automatiquement réalisées sur la base de l'impulsion d'horloge et étant indépendantes des opérations de régénération extérieures.

2. Carte à mémoire suivant la revendication 1 dans laquelle
les moyens de commande de lecture-écriture comportent un circuit (24) de production de signal de lecture-écriture destiné à produire le signal de commande de lecture-écriture et un signal d'activation, et un premier multiplexeur (25) destiné à appliquer le signal d'adressage extérieur vers la DRAM (102) en réponse au signal d'activation ;
les moyens de réglage d'opérations de lecture-écriture/régénération comprenant en outre un circuit (31) de réglage de la durée d'activation d'opération de lecture-écriture dans lequel la durée d'opération de lecture-écriture de la DRAM (102) est fixée de manière arbitraire, et un circuit (30) comparateur recevant la valeur comptée et la durée d'opération de lecture-écriture fixée et destiné à émettre en sortie soit le signal (36) de sélection de régénération soit le signal (36) de sélection de lecture-écriture ;
les moyens de sélection de lecture-écriture/régénération comportant un second multiplexeur (28) recevant le signal de commande de lecture-écriture et le signal de commande de régénération et ayant son entrée de commande connectée à la sortie du circuit (30) comparateur ;
les moyens (32) d'identification comprenant au moins un registre de signal enregistré et de signal de sélection de lecture-écriture et un signal de sélection de régénération issu du circuit (30) comparateur, et
un troisième multiplexeur (33) qui, en réponse au signal d'adresse et au signal de commande extérieure, sélectionne soit les données de sortie issues du registre pour émettre en sortie par l'intermédiaire d'une ligne (23) de données, soit les données de mémoire pour émettre en sortie à partir de la DRAM par l'intermédiaire de la ligne de données ou pour émettre en entrée vers la DRAM par l'intermédiaire de la ligne de données.

3. Carte à mémoire suivant la revendication 2, dans laquelle un circuit (38) à retard est inséré entre le circuit (30) comparateur et le second multiplexeur (28) pour retarder le temps de mise en oeuvre de l'opération de régénération.
